# EUROPEAN PATENT APPLICATION

(11) **EP 4 480 897 A1**
(43) Date of publication of application: **25.12.2024**
(21) Application number: 23180420.4
(22) Date of filing: 20.06.2023
(51) Int. Cl.: B81B 7/00, H04R 19/00

(54) **COMBINED SOUND TRANSDUCER AND PRESSURE SENSOR PACKAGE**

(71) Applicant: Infineon Technologies AG, 85579 Neubiberg (DE)
(72) Inventor: RIEDER, Bernhard, 93049 Regensburg (DE)
(74) Representative: Fischer, Florian

(57) **Abstract**

A combined sound transducer and pressure sensor package (100) is provided, comprising a plane substrate (110) and a first lid (120) being attached to a first substrate surface (111), wherein a first cavity (130) is defined between the first lid (120) and the first substrate surface (111). A second lid (220) is attached to an opposite second substrate surface (112), wherein a second cavity (230) is defined between the second lid (220) and the second substrate surface (112), and wherein the second lid (220) comprises a fluid opening (240) for allowing a fluid to enter the second cavity (230). A MEMS sound transducer (150) and a MEMS pressure sensor (250) are provided, each being arranged inside opposite ones of the first and second cavities (130, 230). A transfer block (180) for providing an electric path between a package pad (160) and the MEMS sound transducer (150) and the MEMS pressure sensor (250) is provided as a discrete component separate from the substrate (110).

## Description

### GENERAL DESCRIPTION

Embodiments of the present disclosure relate to housed electronic components, and in particular to microstructured MEMS (Micro Electro Mechanical System) pressure sensors, such as environmental pressure sensors, and to microstructured MEMS sound transducers, such as microphones or speakers. In particular, the herein described innovative concept is concerned with a combined sound transducer and pressure sensor package, in which a MEMS pressure transducer and a MEMS sound transducer are commonly housed.

### TECHNICAL BACKGROUND

MEMS pressure sensors and MEMS sound transducers are an integral part of nowadays consumer electronics. For example, smartphones, tablets, smart watches, and the like, are usually equipped with one or more sound transducers, such as microphones and speakers, and with pressure sensors, such as environmental barometric pressure sensors for determining an altitude or the like. In addition, these consumer devices comprise an ever increasing amount of additional integrated electronic components in order to satisfy the consumers' increasing needs and desires for additional features. At the same time, however, the size and form factor of the devices tends to decrease. Thus, there is a trade off between an increase of electronic components and a decrease of available assembly space.

In some instances, assembly space inside a casing of an electronic device may be highly limited, such that manufacturers of integrated electronic components need to find new solutions for installing their components into small-sized devices. One of the challenging tasks is to properly fit MEMS pressure sensors and MEMS sound transducers into one common casing of a consumer electronics device, since these MEMS components need additional space for fluid channels for communicating with the environment.

For example, sound transducers and pressure sensors need their own fluid channels, for allowing pressure and sound waves to enter the casing. Thus, one physical channel connected with the MEMS pressure sensor and one additional physical channel connected with the MEMS sound transducer has to be provided. At the same time, two physical entry ports / openings have to be provided in the casing which increases the risk of undesired ingress of moisture, dust, environmental particles and the like. Some manufacturers provide so called flex brackets, which act as internal port dividers inside the casing, such that only one physical port (opening) needs to be provided in the casing.

Furthermore, a MEMS pressure sensor and a MEMS sound transducer are each housed inside individual packages. Of course, this does not only increase costs, but it also consumes the already limited available assembly space inside the device's casing. Thus, some manufacturers combined a MEMS pressure sensor and a MEMS sound transducer into one common package, which led to very bulky packages.

Furthermore, in order to allow fluid to enter the respective package, each package has to comprise a fluid port / opening connected to the above mentioned fluid channel. A combined sensor package may have the advantage that only one fluid port has to be provided. However, a MEMS sound transducer shall be mounted such that it covers the fluid port in order to provide a large back volume increasing the sound transducer's overall performance. Accordingly, the MEMS sound transducer is mounted in front of the MEMS pressure sensor in the fluid path. Since the membrane of the MEMS sound transducer attenuates the arriving pressure waves, this may lead to faulty pressure sensing by the subsequently arranged pressure sensor.

A further advantage of combined sensor packages may be the possibility of a joint package connection, i.e. both the MEMS pressure sensor and the MEMS sound transducer may be electrically connected via package pads being provided at an exterior of the common package. However, as it may be dictated by the limited available assembly space inside a casing, such packages may sometimes need to be installed such that their fluid opening is positioned opposite to the package pads. Accordingly, the package pads and the fluid opening have to be positioned on two opposite sides of the package, which can be a challenging task.

Thus, it would be desirable to provide a combined MEMS sound transducer and MEMS pressure sensor package without the above mentioned drawbacks.

This can be achieved with a combined sound transducer and pressure sensor package according to independent claim 1. The innovative sound transducer and pressure sensor package comprises a plane substrate and a first lid being attached to a first substrate surface, wherein a first cavity is defined between the first lid and the first substrate surface, and wherein the first lid comprises a fluid opening for allowing a fluid to enter the first cavity. The package further comprises a second lid being attached to an opposite second substrate surface, wherein a second cavity is defined between the second lid and the second substrate surface. The substrate comprises a through hole for providing a fluid communication between the first and second cavities. A MEMS sound transducer is arranged inside one of the first and second cavities, the MEMS sound transducer covering the through hole. A MEMS pressure sensor is arranged inside the other one of the first and second cavities, the MEMS pressure sensor being spaced apart from the through hole. The package comprises one or more package pads for electrically contacting the MEMS sound transducer and the MEMS pressure sensor from outside the package. The one or more package pads and the fluid opening located in the first lid are positioned at two opposite sides of the package. According to the herein described innovative concept, a transfer block is arranged at the second substrate surface, wherein the transfer block is configured to provide an electric path between the one or more package pads and the MEMS sound transducer and the MEMS pressure sensor. Said transfer block is provided as a discrete component separate from the substrate.

In the following, embodiments of the present disclosure are described in more detail with reference to the figures, in which
- Fig. 1: shows a schematic side sectional view of a combined sound transducer and pressure sensor package according an embodiment,
- Fig. 2: shows a schematic side sectional view of a combined sound transducer and pressure sensor package according a further embodiment,
- Fig. 3: shows a schematic side sectional view of a combined sound transducer and pressure sensor package according a further embodiment,
- Fig. 4: shows a schematic side sectional view of a combined sound transducer and pressure sensor package according a further embodiment,
- Fig. 5: shows a schematic side sectional view of a combined sound transducer and pressure sensor package according a further embodiment,
- Fig. 6: shows a schematic side sectional view of a combined sound transducer and pressure sensor package according a further embodiment, and
- Fig. 7: shows a schematic side sectional view of a combined sound transducer and pressure sensor package according a further embodiment.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

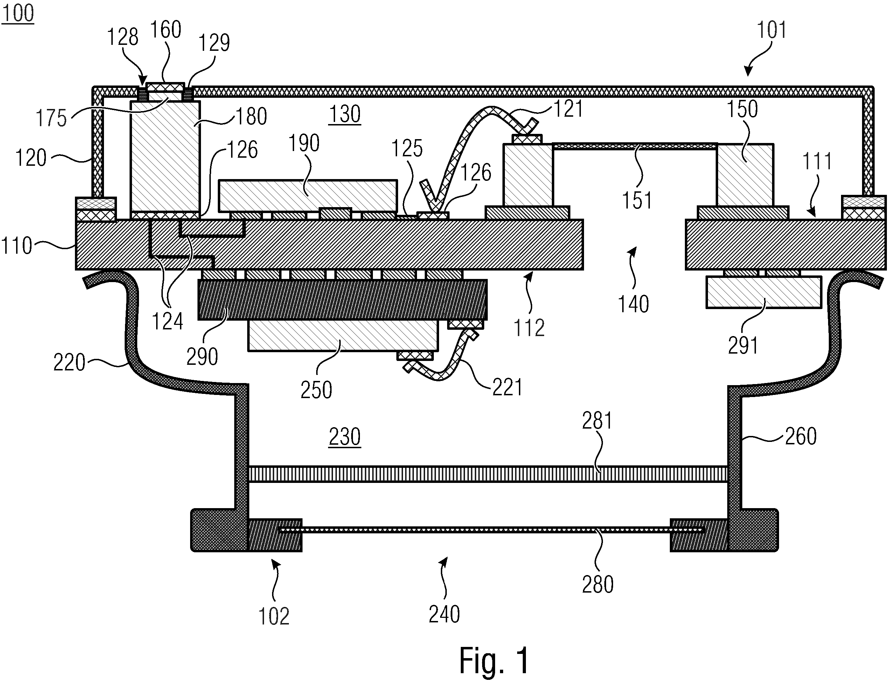

Figure 1 shows a combined sound transducer and pressure sensor package 100 according to an embodiment. The package 100 may be configured for housing microstructured electronic devices. Thus, the package 100 may comprise small dimensions, such as 5 x 5 mm, for example.

The package 100 comprises a plane substrate 110 and a first lid 120 being attached to a first substrate surface 111, wherein a first cavity 130 is defined between the first lid 120 and the first substrate surface 111.

The package 100 further comprises a second lid 220 being attached to an opposite second substrate surface 112, wherein a second cavity 230 is defined between the second lid 220 and the second substrate surface 112. The second lid 220 comprises a fluid opening 240 for allowing a fluid to enter the second cavity 230.

Optionally, an environmental barrier structure 280 may be arranged in or at the fluid opening 240 that is provided in the second lid 220. The environmental barrier structure 280 may serve the purpose of avoiding undesired ingress of environmental dust, moisture, liquids, solid particles, and the like. The environmental barrier structure 280 may be configured as a rigid mesh or as a compliant / flexible membrane. The environmental barrier structure 280 is an optional feature that may be optionally provided in every embodiment discussed herein.

Further optionally, a mechanical stop 281 may be arranged in the fluid opening 240 that is provided in the second lid 220. The mechanical stop 281 may be provided downstream of the environmental barrier structure 280, with regards to a fluid path, in which a fluid enters the second cavity 230. The mechanical stop 281 is configured to limit an amount of deflection of the environmental barrier structure 280. For example, in case the environmental barrier structure 280 may be provided as a flexible membrane, the mechanical stop 281 may avoid undesired over-bending of the environmental barrier structure 280 in that the deflected environmental barrier structure 280 may bump against the mechanical stop 281.

The substrate 110 comprises a through hole 140 for providing a fluid communication between the first and second cavities 130, 230. According to this non-limiting exemplary embodiment, a MEMS sound transducer 150 is arranged inside the first cavity 130. The MEMS sound transducer 150 is mounted at the first substrate surface 111 such that it covers the through hole 140. The substrate 110 itself may be cavity-less, i.e. the substrate 110 itself may comprise no further cavities except from the through hole 140.

A MEMS pressure sensor 250 is arranged inside the second cavity 230 formed by the second lid 220. The MEMS pressure sensor 250 is mounted at the second substrate surface 112 such that it is laterally spaced apart from the through hole 140 in the substrate 110.

The package 100 further comprises one or more package pads 160 for electrically contacting the MEMS sound transducer 150 and the MEMS pressure sensor 250 from outside the package 100. The one or more package pads 160 and the fluid opening 240 in the second lid 220 are positioned at two opposite sides 101, 102 of the package 100.

A rigid transfer block 180 is arranged at the first substrate surface 111. The transfer block 180 is configured to provide an electric path between the one or more package pads 160 and the MEMS sound transducer 150 and the MEMS pressure sensor 250. The transfer block 180 is provided as a discrete component separate from the substrate 110. According to this non-limiting exemplary embodiment, the transfer block 180 is arranged inside the first cavity 130.

The package pad 160 for externally contacting the package 100 may be arranged at the transfer block 180. For example, the first lid 120 may comprise a hole 128 being provided at the first side 101 of the package 100. Said hole 128 may be configured to accommodate an accommodating portion 175 of the transfer block 180. The accommodating portion 175 may be a protruding portion that protrudes from an upper surface of the transfer block 180. Said upper surface may be the surface of the transfer block 180 that faces the first lid 120. The accommodating portion 175 may comprise a smaller width / diameter than the rest of the transfer block 180.

The hole 128 provided in the first lid 120 may be wider than a width of the accommodating portion 175 of the transfer block 180, such that the transfer block 180 is accommodated in the hole 128 by a clearance-fit. A clearance between the accommodating portion 175 and the hole 128 may be filled with bonding material 129, in particular with non-conductive bonding material, such as glue. For example, the non-conductive bonding material 129 may be permanently elastic, such that it is elastic prior to and after curing. For example, the bonding material 129 may comprise a permanently elastic soft glue. Alternatively, the non-conductive bonding material 129 may be temporarily elastic, such that it is elastic prior to curing but non-elastic after curing. For example, the bonding material 129 may comprise solder, which is solid at room temperature, but viscous / flexible at a certain reflow temperature.

For example, the rigid transfer block 180 may be fixedly secured to one of the first substrate surface 111 and the first lid 120, while being (at least temporarily, e.g. during assembly) flexibly secured to the other one of the first substrate surface 111 and the first lid 120. In the exemplary embodiment shown in Figure 1, the rigid transfer block 180 may be fixedly secured to the first substrate surface 111 and flexibly secured to the first lid 120.

The plane substrate 110 may be configured as a rigid substrate. For example, the plane substrate 110 may be configured as a laminated printed circuit board (PCB). The plane substrate 110 may comprise a routed wiring comprising one or more wiring structures for electrically connecting the transfer block 180, the MEMS sound transducer 150 and the MEMS pressure sensor 250 with each other. The routed wiring of the substrate 110 may comprise at least one of one or more conductive surface pads 126, one or more conductive surface traces 125, and one or more integrated conducting layers 124 for providing the above mentioned electric path between the externally contactable package pad 160 and any electronic components residing inside the package 100, such as the MEMS sound transducer 150 and the MEMS pressure sensor 250.

The transfer block 180 may also be rigid. For example, the transfer block 180 may be made from the same or a similar material as the substrate 110, e.g. from a PCB-material. The transfer block 180 may comprise one or more external electric conductors (not explicitly shown) being routed vertically along its outer circumference, and/or one or more internal electric conductors (not explicitly shown) being routed through the inside of the transfer block 180. Said one or more electric conductors may provide a conductive path between a first side of the transfer block 180 facing the first lid 120 and an opposite second side of the transfer block 180 facing the firs substrate surface 111. For example, one or more electric conductors may provide a conductive path between the package pad 160 and a wiring structure 126 of the substrate 110.

Optionally, a first controlling circuitry 190 for controlling the MEMS sound transducer 150 may reside inside the first cavity 130, for example adjacent to the MEMS sound transducer 150 on the same substrate surface 111. The MEMS sound transducer 150 may be coupled to the first controlling circuitry 190 by means of flexible conductors 121, e.g. by bond wires. As exemplarily depicted in Figure 1, the first controlling circuitry 190 may sit in the electric path between the transfer block 180 and the MEMS sound transducer 150. However, the first controlling circuitry 190 is merely optional since it may also be provided outside the package 100.

Further optionally, a second controlling circuitry 290 for controlling the MEMS pressure sensor 250 may reside inside the second cavity 230, for example between the MEMS pressure sensor 250 and the second substrate surface 112. The MEMS pressure sensor 250 may be coupled to the second controlling circuitry 290 by means of flexible conductors 221, e.g. by bond wires. As exemplarily depicted in Figure 1, the second controlling circuitry 290 may sit in the electric path between the transfer block 180 and the MEMS pressure sensor 250. However, the second controlling circuitry 290 is merely optional since it may also be provided outside the package 100. Further optionally, at least one of the first and second controlling circuitries 190, 290 may be configured to control both the MEMS sound transducer 150 and the MEMS pressure sensor 250, such that one of the first and second controlling circuitries 190, 290 can be omitted.

Further optionally, additional passive electronic devices, such as resistors, capacitors and inductors may be provided inside at least one of the first and second cavities 130, 230. For example, one or more integrated passive devices (IPD) 291 can be mounted at one of the first and second substrate surfaces 111, 112.

As exemplarily shown in Figure 1, the first lid 120 may comprise a box-shape, since such a box-shape is easy to manufacture. The first lid 120 may comprise, or be made of, at least one of metal, plastics or ceramics. The second lid 220 may comprise some sort of chimney-shape having a flange 260 extending away from the substrate 110. A sealing ring (not shown) may be provided around the flange 260. For example, the fluid opening 240 of the package 100 may be connected to a fluid channel or a fluid port inside an electronic device (smartphone, etc.). A sealing ring may allow for a fluid tight sealing between the package 100 and the device.

According to the present innovative concept, the MEMS sound transducer 150 and the MEMS pressure sensor 250 are both contained in one common package 100. This package 100 may have a small footprint, since the MEMS sound transducer 150 and the MEMS pressure sensor 250 are arranged on opposite substrate surfaces 111, 112. Fluid from the environment, such as environmental air, may enter the second cavity 230 through the fluid opening 240 provided in the second lid 220. Inside the second cavity 230, the fluid pressure may be sensed by the MEMS pressure sensor 250. The controlling circuitry 290 may create corresponding electric signals that may be routed through the substrate's wiring structures 124, 125, 126 via the transfer block 180 to the externally contactable package pad 160.

The fluid may then flow through the through hole 140 in the substrate 110 where it impinges the membrane 151 of the MEMS sound transducer 150. The membrane 151 may oscillate in response to the impinging sound waves, wherein the controlling circuitry 190 may create corresponding electric signals that may be routed through the substrate's wiring structures 124, 125, 126 via the transfer block 180 to the externally contactable package pad 160.

It may be advantageous to arrange the MEMS sound transducer 150 and the MEMS pressure sensor 250 in the way as discussed with reference to Figure 1, since the fluid entering the fluid opening 240 in the second lid 220 firstly arrives at the MEMS pressure sensor 250 before arriving at the MEMS sound transducer 150. Otherwise, the membrane 151 of the MEMS sound transducer 150 may attenuate some pressure of the entered fluid, which may lead to a mitigated signal-to-noise ratio (SNR) of the MEMS pressure sensor 250 or to faulty pressure measurements.

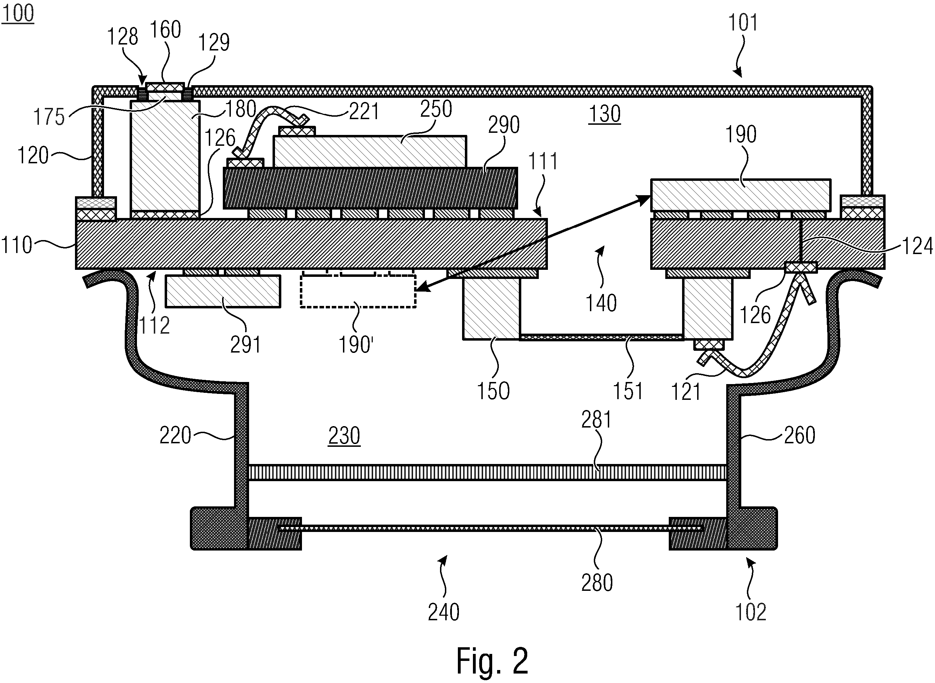

Figure 2 shows a further embodiment of the package 100, wherein like elements with like or similar functionality as in Figure 1 are denoted with like reference numerals. Thus, everything that has been discussed with reference to Figure 1 also holds for the embodiment as shown in Figure 2, and vice versa.

According to Figure 2, the MEMS pressure sensor 250 is arranged inside the first cavity 130 and the MEMS sound transducer 150 is arranged inside the second cavity 230, such that a fluid entering the second cavity 230 through the fluid opening 240 in the second lid 220 firstly arrives at the MEMS sound transducer 150 before arriving at the MEMS pressure sensor 250.

In other words, the MEMS sound transducer 150 is mounted at the second substrate surface 112 such that it covers the through hole 140. The MEMS pressure sensor 250 is arranged at the first substrate surface 111, being laterally spaced apart from the through hole 140.

This embodiment may be advantageous since the first control circuitry 190 for controlling the MEMS sound transducer 150 may be arranged on the opposite substrate surface than the MEMS sound transducer 150 itself. For example, the MEMS sound transducer 150 may be mounted at the second substrate surface 112, while the first control circuitry 190 may be mounted at the first substrate surface 111. The MEMS sound transducer 150 and the first control circuitry 190 may be coupled to each other via the wiring structures 124, 125, 126 of the substrate 110. This embodiment may save assembly space inside the package 100.

Alternatively, the first control circuit 190 may be arranged at the second substrate surface 112, as schematically indicated by means of the first control circuit 190' being drawn in dashed lines. In this case, additional assembly space for integrating further components may be available at the first substrate surface 111.

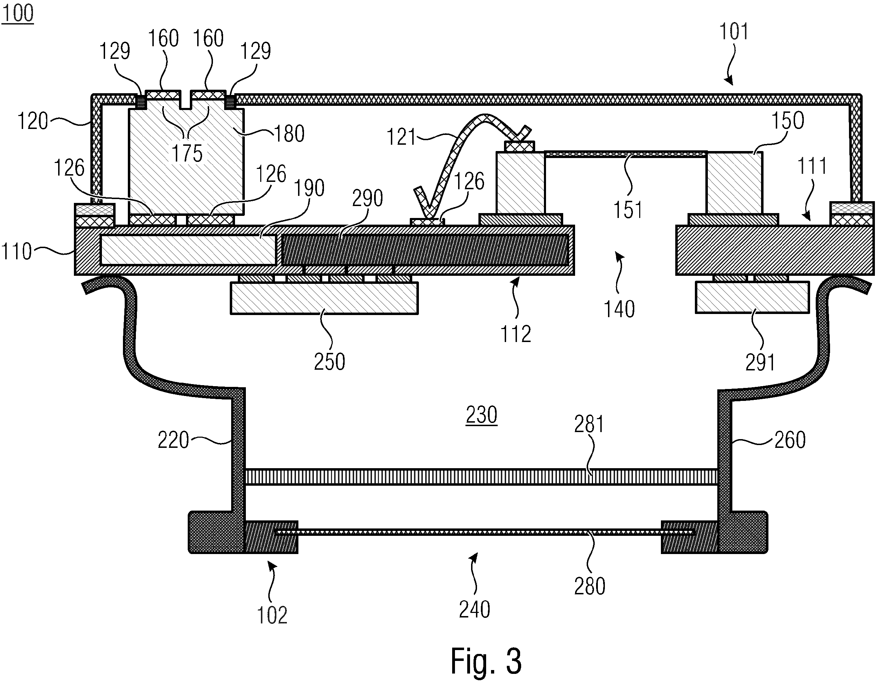

Figure 3 shows a further embodiment of the package 100, wherein like elements with like or similar functionality as in the previous Figures are denoted with like reference numerals. Thus, everything that has been discussed with reference to the previous Figures also holds for the embodiment as shown in Figure 3, and vice versa.

According to Figure 3, at least one of the optionally available first and second controlling circuitries 190, 290 may be integrated inside the plane substrate 110. The MEMS sound transducer 150 and the MEMS pressure sensor 250 may be coupled to the first and second control circuitries 190, 290 via at least one of the substrate's wiring structures 124, 125, 126, in particular via integrated conductive layers 124 provided inside the substrate 110 (not explicitly shown here).

This embodiment may be advantageous since additional assembly space for integrating further components may be available at both the first and second substrate surfaces 111, 112. Moreover, both the MEMS sound transducer 150 and the MEMS pressure sensor 250 may be arranged on the same substrate surface 111, 112.

Furthermore, as exemplarily depicted in Figure 3, the transfer block 180 may comprise two or more of the above discussed accommodating portions 175. Each of the accommodating portions 175 may comprise a package pad 160 for externally contacting the MEMS sound transducer 150 and the MEMS pressure sensor 250 from outside the package 100. The transfer block 180 may be coupled to the electric path via two or more of the substrate's wiring structures 124, 12, 126.

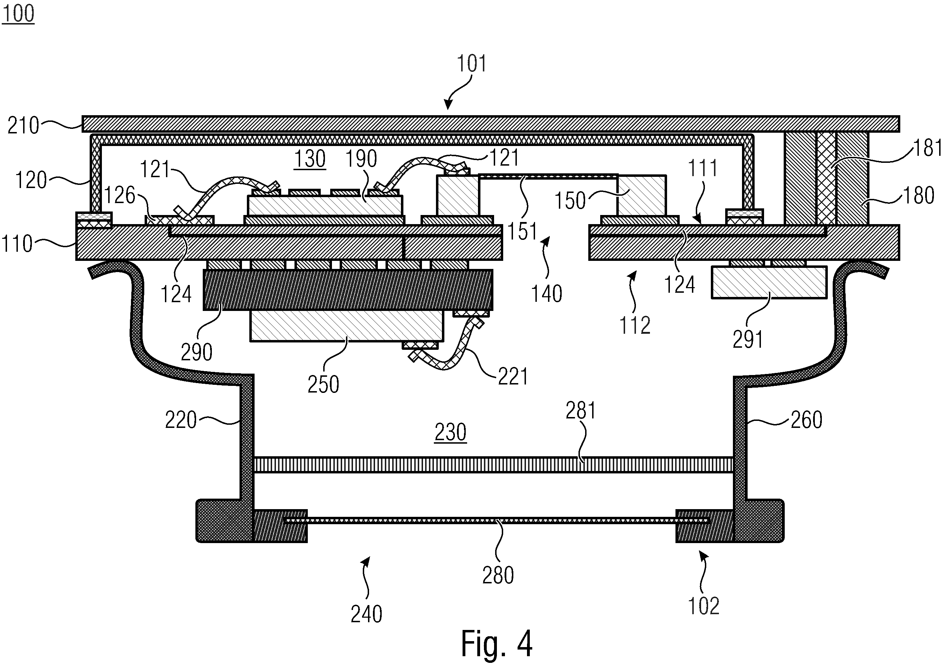

Figure 4 shows a further embodiment of the package 100, wherein like elements with like or similar functionality as in the previous Figures are denoted with like reference numerals. Thus, everything that has been discussed with reference to the previous Figures also holds for the embodiment as shown in Figure 4, and vice versa.

According to Figure 4, the transfer block 180 may be arranged outside the first cavity 130 adjacent to the first lid 120. The transfer block 180 may be mounted at the first substrate surface 111. At an opposite end face of the transfer block 180, one or more of the above discussed package pads 160 (not visible here) may be provided for contacting the MEMS sound transducer 150 and the MEMS pressure sensor 250 from outside the package 100.

As exemplarily depicted in Figure 4, the innovative package 100 may be coupled to a separate component board 210, which may be part of a device (e.g., smartphone, etc.) inside of which the innovative package 100 may be installed. The component board 210 may be arranged at a first package side 101 opposite to the first substrate surface 111. The transfer block 180 may be arranged between the substrate 110 and said component board 210. For instance, the transfer block 180 may be mechanically and galvanically coupled to the component board 210, e.g. by means of the aforementioned one or more package pads 160.

The component board 210 may be configured as a plane and rigid substrate. A height of the transfer block 180 and a height of the first lid 120 may be substantially the same. That means, the height of the transfer block 180 may deviate from the height of the first lid 120 by less than ± 20%, or less than ± 10%. Accordingly, the component board 210 may rest at an exterior surface of the first lid 120, in particular at an exterior surface that faces away from the substrate 110. Thus, the innovative package 100 may be directly mounted onto the component board 210, such that the first lid 120 is in direct contact with the component board 210, which significantly reduces the assembly space needed for installing the package 100. Accordingly, a height of the mounted package 100 can be significantly reduced even though the fluid opening 240 and the package pads 160 are positioned at two opposite sides of the package 100.

The component board 210 may comprise wiring structures (not explicitly shown) as previously discussed with respect to the substrate 110, e.g. conductive surface pads and/or conductive traces and/or integrated conductive layers. Via said wiring structures, a conductive path between the component board 210 and the transfer block 180 may be established, with the one or more package pads 160 sitting between the transfer block 180 and the component board 210 in said conductive path.

The transfer block 180 may comprise one or more internal and/or external electric conductors 181 being routed vertically along its outer circumference or through the inside of the transfer block 180, respectively. Said one or more electric conductors 181 may provide a conductive path between the substrate 110 and the component board 210.

For example, the electric conductors 181 may provide a conductive path between the component board 210 and a wiring structure 124, 125, 126 of the substrate 110. Via said wiring structure 124, 125, 126 of the substrate 110, the MEMS sound transducer 150 and the MEMS pressure sensor 250 may be coupled to the transfer block 180 as described above. Accordingly, an electric path may be provided between at least one of the package pad 160 and the transfer block 180 and the MEMS sound transducer 150 and the MEMS pressure sensor 250, even though the transfer block 180 may be arranged outside the package 100.

In addition, a transfer block 180 as previously discussed with reference to the previous Figures may be provided inside the first cavity 130. In this case, the package pads 160 protruding from the first lid 120 may be connected to a wiring structure of the component board 210.

According to the embodiment shown in Figure 4, the MEMS sound transducer 150 may be arranged inside the first cavity 130 formed between the first lid 120 and the first substrate surface 111 of the substrate 110. The MEMS pressure sensor 250 may be arranged inside the second cavity 230 formed between the second lid 220 and the second substrate surface 112 of the substrate 110. This arrangement may substantially correspond to the arrangement as previously discussed above with reference to Figure 1. Thus, everything that was mentioned above also holds for the embodiment as shown in Figure 4.

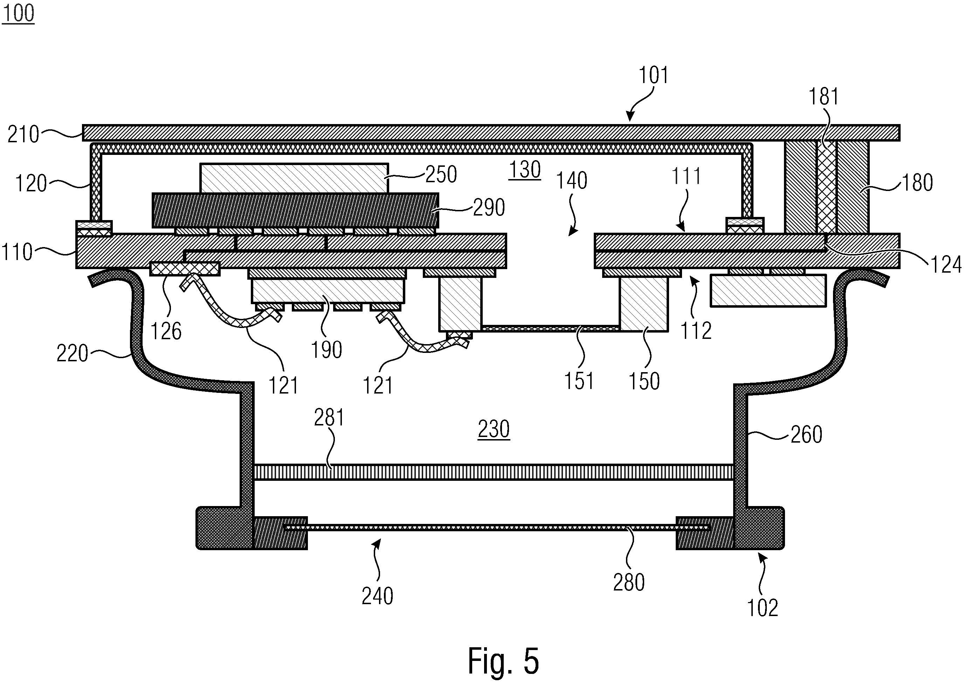

Figure 5 shows a further embodiment of the package 100, wherein like elements with like or similar functionality as in the previous Figures are denoted with like reference numerals. Thus, everything that has been discussed with reference to the previous Figures also holds for the embodiment as shown in Figure 5, and vice versa.

In comparison with Figure 4, the arrangement of Figure 5 is switched, i.e. the MEMS sound transducer 150 may be arranged inside the second cavity 230 between the second lid 220 and the second substrate surface 112 of the substrate 110, while the MEMS pressure sensor 250 may be arranged inside the first cavity 130 formed between the first lid 120 and the first substrate surface 111 of the substrate 110. This arrangement may substantially correspond to the arrangement as previously discussed above with reference to Figure 2. Thus, everything that was mentioned above also holds for the embodiment as shown in Figure 5.

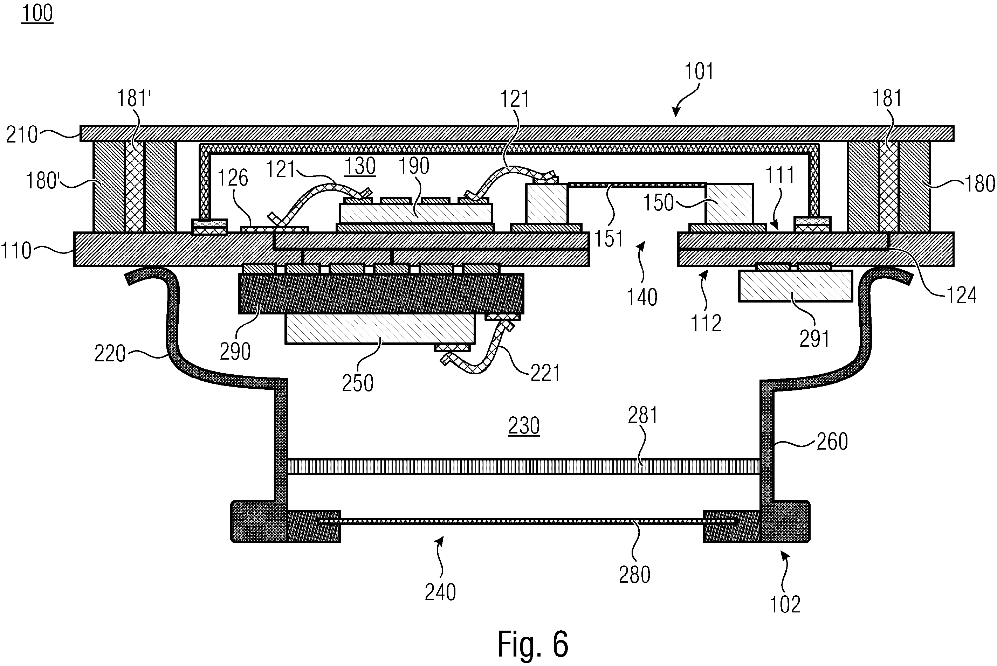

Figure 6 shows a further embodiment of the package 100, wherein like elements with like or similar functionality as in the previous Figures are denoted with like reference numerals. Thus, everything that has been discussed with reference to the previous Figures also holds for the embodiment as shown in Figure 6, and vice versa.

The embodiment as shown in Figure 6 substantially corresponds to the embodiment as previously discussed with reference to Figure 4. Thus, everything that has been discussed with reference to the previous Figures also holds for the embodiment as shown in Figure 6, and vice versa. In addition, the package 100 according to Figure 6 may comprise a further transfer block 180' being arranged outside the first cavity 130 and adjacent to the first lid 120. As exemplarily depicted, both the transfer block 180 and the further transfer block 180' may be positioned on opposite lateral sides (e.g. left and right) of the first lid 120. However, it may also be possible that both the transfer block 180 and the further transfer block 180' may be positioned on the same lateral side of the first lid 120.

A component board 210 may be arranged at an exterior surface of the first lid 120, in particular at an exterior surface that faces away from the substrate 110. The transfer block 180 and the further transfer block 181' may be arranged between the substrate 110 and the component board 210.

Each one of the transfer blocks 180, 180' may comprise one or more of the previously discussed package pads 160 (not visible here) for electrically contacting the MEMS sound transducer 150 and the MEMS pressure sensor 250 from outside the package 100. In particular, the one or more package pads 160 may be arranged between the respective transfer block 180, 180' and the component board 210. The component board 210 may be mechanically and/or electrically connected to the transfer blocks 180, 180', e.g. by means of the one or more package pads 160 being arranged at the respective transfer block 180, 180'.

The further transfer block 180' may comprise one or more internal and/or external electric conductors 181' being routed vertically along its outer circumference or through the inside of the further transfer block 180', respectively. Said one or more electric conductors 181' of the further transfer block 181' may provide a conductive path between the substrate 110 and the component board 210.

For example, the electric conductors 181' may provide a conductive path between the component board 210 and a wiring structure 124, 125, 126 of the substrate 110. Via said wiring structure 124, 125, 126 of the substrate 110, the MEMS sound transducer 150 and the MEMS pressure sensor 250 may be coupled to at least one of the transfer block 180 and the further transfer block 180', as described above. Accordingly, an electric path may be provided between at least one of the package pads 160 and one of the transfer blocks 180, 180' and the MEMS sound transducer 150 and the MEMS pressure sensor 250, even though the transfer blocks 180, 180' may be arranged outside the package 100.

In the embodiment of Figure 6, the position of the MEMS sound transducer 150 and the MEMS pressure sensor 250 may be switched, such as exemplarily shown in Figure 5. Additionally, a further transfer block may optionally be arranged inside the first cavity 130, such as exemplarily depicted in Figure 1.

The arrangement as depicted in Figure 6 may be advantageous since the transfer blocks 180, 180' being arranged on two opposite lateral sides of the first lid 120 may provide for a symmetric design that balances a mechanical load during assembly of the package 100 or replacement of components thereof. Furthermore, the symmetric design may increase the number of transfer channels which can be provided for the number of connections between the MEMS sound transducer 150 and the MEMS pressure sensor 250.

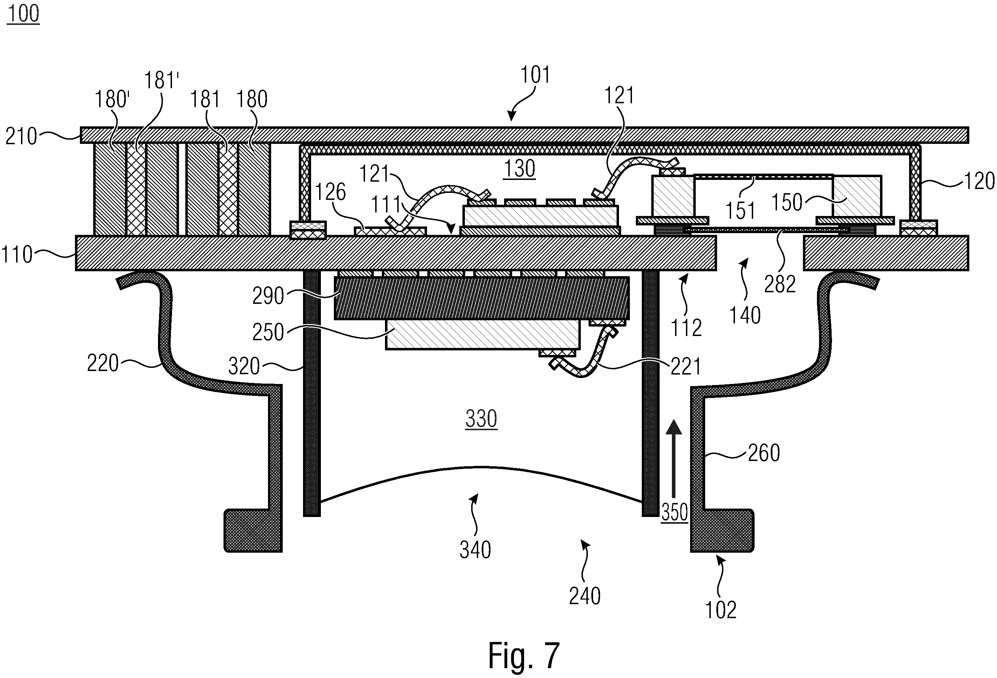

Figure 7 shows a further embodiment of the package 100, wherein like elements with like or similar functionality as in the previous Figures are denoted with like reference numerals. Thus, everything that has been discussed with reference to the previous Figures also holds for the embodiment as shown in Figure 7, and vice versa.

According to Figure 7, the transfer block 180, and optionally a further transfer block 180' may be arranged on the first substrate surface 111, e.g. adjacent to the first lid 120 and at the same lateral side of the first lid 120.

In addition to the previously discussed embodiments, the package according to Figure 7 may comprise a shell 320 laterally surrounding the MEMS pressure sensor 250, wherein the shell 320 may be arranged at the second substrate surface 112. The shell 320 may be arranged inside the second cavity 230. The shell 320 may be positioned inside the second lid 220, e.g. being laterally surrounded by the second lid 220.

An interior of the shell 320 may be filled with a flexible pressure transmitting material 330, said flexible pressure transmitting material encapsulating the MEMS pressure sensor 250. The shell 320 may comprise an opening 340 being in fluid communication with the fluid opening 240 provided in the second lid 220, such that a fluid entering the second cavity 230 through the fluid opening 220 contacts the flexible pressure transmitting material 330 for transmitting the fluid pressure towards the MEMS pressure sensor 250. The opening 340 may be provided at a side of the shell 320 that faces away from the second substrate surface 112.

The shell 320 may comprise an outer diameter that is smaller than an inner diameter of the second lid 220. Accordingly, some clearance between the shell 320 and the second lid 220 may remain which may provide for a fluid path 350 allowing fluid to flow into the direction of the through hole 140 provided in the substrate 110. Thus, fluid that enters the second cavity 230 through the fluid opening 240 may stream past the shell 340 so as to arrive at the through hole 140 and, thus, at the subsequently arranged MEMS sound transducer 150.

Optionally, an environmental barrier structure 282 may be arranged between the MEMS sound transducer 150 and the first substrate surface 111, wherein the environmental barrier structure 282 may cover the through hole 140. Additionally or alternatively, an environmental barrier structure 282 may be arranged at the opposite second substrate surface 112, wherein the environmental barrier structure 282 may cover the through hole 140 from the opposite second side. The environmental barrier structure 282 may be provided alternatively or in combination with the previously discussed environmental barrier structure 280.

The environmental barrier structure 282 may be provided in each and every embodiment as discussed herein. Furthermore, the shell 320 may be combined with each and every embodiment as discussed herein. It is to be noted that all embodiments discussed herein are not to be considered as isolated embodiments. Instead, all embodiments may be combined with each other, wherein all features comprising the same reference numerals may be interchanged with each other.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A combined sound transducer and pressure sensor package (100) comprising:
a plane substrate (110),
a first lid (120) being attached to a first substrate surface (111), wherein a first cavity (130) is defined between the first lid (120) and the first substrate surface (111),
a second lid (220) being attached to an opposite second substrate surface (112), wherein a second cavity (230) is defined between the second lid (220) and the second substrate surface (112), and wherein the second lid (220) comprises a fluid opening (240) for allowing a fluid to enter the second cavity (230),
wherein the substrate (110) comprises a through hole (140) for providing a fluid communication between the first and second cavities (130, 230),
a MEMS sound transducer (150) being arranged inside one of the first and second cavities (130, 230), the MEMS sound transducer (150) covering the through hole (140),
a MEMS pressure sensor (250) being arranged inside the other one of the first and second cavities (130, 230), the MEMS pressure sensor (250) being spaced apart from the through hole (140),
one or more package pads (160) for electrically contacting the MEMS sound transducer (150) and the MEMS pressure sensor (250) from outside the package (100),
wherein the one or more package pads (160) and the fluid opening (240) in the second lid (220) are positioned at two opposite sides (101, 102) of the package (100), and
a transfer block (180) being arranged at the first substrate surface (111) and being configured to provide an electric path between the one or more package pads (160) and the MEMS sound transducer (150) and the MEMS pressure sensor (250), wherein the transfer block (180) is provided as a discrete component separate from the substrate (110).

2. The combined sound transducer and pressure sensor package (100) according to claim 1,
wherein the MEMS sound transducer (150) is arranged inside the first cavity (130), and
wherein the MEMS pressure sensor (250) is arranged inside the second cavity (230),
such that a fluid entering the second cavity (230) through the fluid opening (240) in the second lid (220) firstly arrives at the MEMS pressure sensor (250) before arriving at the MEMS sound transducer (150).

3. The combined sound transducer and pressure sensor package (100) according to claim 1,
wherein the MEMS pressure sensor (250) is arranged inside the first cavity (130), and
wherein the MEMS sound transducer (150) is arranged inside the second cavity (230),
such that a fluid entering the second cavity (230) through the fluid opening (240) in the second lid (220) firstly arrives at the MEMS sound transducer (150) before arriving at the MEMS pressure sensor (250).

4. The combined sound transducer and pressure sensor package (100) according to any one of claims 1 to 3,
wherein the transfer block (180) is arranged inside the first cavity (130).

5. The combined sound transducer and pressure sensor package (100) according to any one of claims 1 to 3,
wherein the transfer block (180) is arranged outside the first cavity (130) adjacent to the first lid (120).

6. The combined sound transducer and pressure sensor package (100) according to any one of claims 1 to 3,
comprising a further transfer block (180'), wherein the transfer block (180) and the further transfer block (180') are both arranged outside the first cavity (130) and adjacent to the first lid (120), but on opposite lateral sides of the first lid (120).

7. The combined sound transducer and pressure sensor package (100) according to any one of claims 1 to 6,
wherein the one or more package pads (160) are provided at the transfer block (180) opposite to the first substrate surface (111).

8. The combined sound transducer and pressure sensor package (100) according to any one of claims 1 to 7,
wherein the transfer block (180) comprises a height that substantially corresponds to a height of the first lid (120), and
wherein the one or more package pads (160) are configured for coupling the transfer block (180) to a separate component board (210) being arranged at an outer surface of the first lid (120).

9. The combined sound transducer and pressure sensor package (100) according to claim 8,
wherein the one or more package pads (160) are arranged between the transfer block (180) and the component board (210) for providing a conductive path between a wiring of the component board (210) and the transfer block (180).

10. The combined sound transducer and pressure sensor package (100) according to any one of claims 3 to 9,
comprising a shell (320) laterally surrounding the MEMS pressure sensor (250), wherein the shell (320) is arranged at the second substrate surface (112),
wherein an interior of the shell (320) is filled with a flexible pressure transmitting material (330), said flexible pressure transmitting material (330) encapsulating the MEMS pressure sensor (250),
wherein the shell (320) comprises an opening (340) being in fluid communication with the fluid opening (240) provided in the second lid (220),
such that a fluid entering the second cavity (230) through the fluid opening (240) contacts the flexible pressure transmitting material (330) for transmitting the fluid pressure towards the MEMS pressure sensor (250).

11. The combined sound transducer and pressure sensor package (100) according to claim 10,
comprising an environmental barrier structure (282) covering the through hole (140) provided in the plane substrate (110).

12. The combined sound transducer and pressure sensor package (100) according to any one of claims 1 to 11,
comprising an environmental barrier structure (280) being arranged in or at the fluid opening (240) provided in the second lid (220).

13. The combined sound transducer and pressure sensor package (100) according to claim 12,
comprising a mechanical stop (281) being provided downstream of the environmental barrier structure (280), with regards to a fluid path, in which a fluid enters the second cavity (230),
said mechanical stop (281) being configured for limiting a deflection of the environmental barrier structure (280).

14. The combined sound transducer and pressure sensor package (100) according to any one of claims 1 to 13,
wherein the plane substrate (110) comprises a routed wiring (124, 125, 126) for electrically connecting the transfer block (180) and the MEMS sound transducer (150) and the MEMS pressure sensor (250) with each other.

15. The combined sound transducer and pressure sensor package (100) according to any one of claims 1 to 14,
comprising a controlling circuitry (190, 290) for controlling at least one of the MEMS sound transducer (150) and the MEMS pressure sensor (250), said controlling circuitry (190, 290) being integrated in the plane substrate (110).

16. The combined sound transducer and pressure sensor package (100) according to any one of the preceding claims,
wherein the transfer block (180) comprises at least one electrical conductor passing through the inside of the transfer block (180).

17. The combined sound transducer and pressure sensor package (100) according to any one of the preceding claims,
wherein the transfer block (180) is fixedly secured to one of the first substrate surface (111) and the first lid (120), while being flexibly secured to the other one of the first substrate surface (111) and the first lid (120).

18. The combined sound transducer and pressure sensor package (100) according to any one of the preceding claims,
wherein the first lid (120) comprises a hole (128) that is configured to accommodate an accommodating portion (175) of the transfer block (180),
wherein said hole (128) in the first lid (120) is wider than a width of the accommodating portion (175) of the transfer block (180), such that the transfer block (180) is accommodated in the hole (128) by a clearance-fit.

19. The combined sound transducer and pressure sensor package (100) according to claim 18,
wherein the transfer block (180) is attached to the hole (128) in the first lid (120) by means of at least one of solder or glue.
